# EUROPÄISCHE PATENTSCHRIFT

(11) **EP 1 280 246 B1**
(45) Veröffentlichungstag und Bekanntmachung des Hinweises auf die Patenterteilung: **08.03.2006**
(21) Anmeldenummer: 01117652.6
(22) Anmeldetag: 25.07.2001
(51) Int. Cl.: H01S 3/036

(54) **Gasentladungslaser**
Gas discharge laser
Laser à décharge dans le gaz

(43) Veröffentlichungstag der Anmeldung: 29.01.2003
(73) Patentinhaber: Tuilaser AG, 82110 Germering (DE)
(72) Erfinder: Geiger, Stephan, 85241 Hebertshausen (DE); Strowitzki, Claus, 82205 Gilching (DE); Pflanz, Tobias, 80469 München (DE); Matern, Ansgar, 82110 Germering (DE); Petracek, Thomas, 81241 München (DE); Kappels, Martin, 82237 Wörthsee (DE); Görtler, Andreas, Dr., 86947 Weil (DE)
(74) Vertreter: Maiwald Patentanwalts GmbH

(56) Entgegenhaltungen:
- EP-A- 0 669 047
- US-A- 5 029 177
- US-A- 5 917 066
- PATENT ABSTRACTS OF JAPAN vol. 012, no. 115 (E-599), 12. April 1988 (1988-04-12) & JP 62 243380 A (MITSUBISHI ELECTRIC CORP), 23. Oktober 1987 (1987-10-23)

## Beschreibung

### Technisches Gebiet

Die vorliegende Erfindung betrifft einen Gasentladungslaser mit einer Entladungsröhre, in der sich ein Gas befindet und die zumindest ein Fenster aufweist, durch das ein Laserstrahl austritt oder an dem der Laserstrahl reflektiert wird. Es ist zumindest eine Gasentnahmestelle zur Entnahme einer Teilmenge des in der Entladungsröhre befindlichen Gases vorhanden. Die entnommene Gasmenge wird durch ein Filtermittel geführt und an zumindest einer Gaseinleitungsstelle im Bereich des Fensters eingeleitet.

Die Erfindung betrifft ferner ein Verfahren zum Betreiben eines Gasentladungslasers mit Entladungsröhre, in der sich ein Gas befindet und die zumindest ein Fenster aufweist, durch das ein Laserstrahl austritt oder an dem der Laserstrahl reflektiert wird. Es wird zumindest eine Teilmenge des in der Entladungsröhre enthaltenen Gases entnommen, mit einem Filtermittel gereinigt und im Bereich des zumindest einen Fensters wieder eingeleitet, und zwar derart, dass ein vom Fenster weg gerichteter Gasstrom entsteht. Das kann beispielsweise dadurch erreicht werden, dass der gereinigte Gasstrom auf das Fenster gerichtet wird, wodurch das Fenster von eventuellen Staubpartikeln und anderen Anhaftungen freigespült wird, woraufhin der Gasstrom dann in eine vom Fenster weg gerichtete Richtung abgelenkt wird. Durch diese Ablenkung des Gasstroms wird das Eindringen von Staubpartikeln aus dem Innern der Entladungsröhre möglichst verhindert, zumindest aber erschwert.

Schließlich betrifft die Erfindung eine neue Verwendung eines Filtermittels in dem vorgenannten technischen Gebiet.

### Stand der Technik

In Gasentladungslasern - insbesondere Excimer-Lasern - wird ein Gas durch Anregungs- und/oder Entladungsreaktion zur Emittierung von Licht angeregt. Die insbesondere für Excimer-Laser geeigneten Molekül- bzw. Atomverbindungen, die nachfolgend auch der Einfachheit halber als Gas oder Gase bezeichnet werden, weisen Energieübergänge auf, durch die vornehmlich elektromagnetische Strahlung im ultravioletten Spektralbereich emittiert wird. Daher stellen heute Excimer-Laser die weitaus intensivsten UV-Strahlungsquellen dar. Jedoch ist zur Anregung der Gase zu Erzeugung stimulierter Emission eine hohe Energiedichte nötig, die in Form eines intensiven, gepulsten Elektronenstrahls oder im Rahmen einer Hochspannungsentladung zugeführt wird, da der Wirkungsquerschnitt für stimulierte Emission für die einzelnen Ausgangsverbindungen innerhalb des Gases relativ klein ist.

Bei der technischen Auslegung derartiger Gasentladungslaser und insbesondere bei Excimer-Lasem ist aus diesem Grunde ein besonders hoher Aufwand in der konstruktiven und apparativen Auslegung der für die gezielte Energiezufuhr erforderlichen Komponenten gelegt werden. Aufgrund der sehr hohen Energien, die im Excimer-Gas zugeführt werden müssen, treten überdies systembedingt Verunreinigungen auf, die beispielsweise durch lokalen Elektrodenabbrand durch Verbindungsreaktion zwischen dem Gas und den einzelnen Laserkomponenten herrühren. Die Verunreinigungen beeinträchtigen jedoch nicht nur den Laserprozess als solchen, sondern vermögen durch Ablagerungen an der Innenwand des das Gas einschließenden Gasraums und insbesondere im Bereich der eingangs erwähnten Fenster des Lasers die Strahlaustrittsintensität des Lasers erheblich zu reduzieren. Derartige Ablagerungen oder Staubpartikel können also die Durchlässigkeit eines Austrittsfensters bzw. das Reflexionsvermögen eines Spiegels in einer Entladungsröhre stark beeinträchtigen. Insbesondere bei Lasern mit kurzer Wellenlänge wie UV-Lasern tritt dieses Problem verstärkt auf.

Zur Verhinderung und Verringerung von Staubablagerungen sind verschiedene Lösungsversuche bekannt. So ist aus der US 4,534,034 ein gepumpter Gasentladungslaser bekannt, bei dem das in der Entladungsröhre befindliche Gas mittels einer daran angeschlossenen, aber außerhalb der Entladungsröhre befindlichen Umwälzpumpe durch ein elektrostatisches Filter gefördert wird, um im Gas befindliche Staubpartikelchen etc. herauszufiltern. Der gereinigte Gasstrom wird jeweils nach Durchlaufen einer besonderen Beruhigungszone im Bereich eines Fensters der Entladungsröhre eingeleitet, so dass durch den Gasstrom die Fenster möglichst sauber gehalten werden, also frei von Staubpartikeln oder sonstigen Ablagerungen. Diese Lösung ist mit dem Problem behaftet, dass elektrostatische Staubabscheider relativ großvolumig sind und eine separate Spannungsversorgung benötigen. Außerdem sind hier aufwendige Beruhigungszonen im Gasfördersystem notwendig.

In der US 5,029,177 ist ein Excimer-Laser offenbart, bei dem ebenfalls ein elektrostatisches Filter zum Reinigen des Gases in der Entladungsröhre vorgesehen ist. Zur Förderung des Gasstroms durch das elektrostatische Filter wird die in der Entladungsröhre befindliche Lüfterwalze eingesetzt. Das im elektrostatischen Filter gereinigte Gas strömt über einen Ringspalt unmittelbar vor einem Fenster der Entladungsröhre ein. Der Vorraum vor den Fenstern besitzt eine Struktur, welche die Schockwellen von der Entladung bricht und die Gasströmung und Bewegung von Staubpartikeln von der Entladung zum Fenster hin behindert.

Aus der EP 0 669 047 B1 sind zudem Einrichtungen zum Aufrechterhalten eines sauberen Laserfensters bekannt. Hier ist insbesondere die Struktur des Vorraums vor dem Fenster näher beschrieben. Die besondere Struktur des Vorraums dient - wie bei den zuvor genannten Druckschriften - dazu, einen vom Fenster weg in Richtung der Entladung gerichteten Gasstrom zu schaffen, um die Bewegung von Staub in den Vorraum vor dem Fenster zu behindern. Hier ist zudem offenbart, dass neben dem in der Entladungsröhre befindlichen Gas ein zweites Gas zum Einsatz kommt. Zur Vermeidung einer elektrischer Ladung der Gase wird ein elektrisch geerdeter Schirm vor dem Fenster vorgeschlagen.

US-A-5 917 066 offenbart Sinterfilter für die Reinigung von Gasen.

### Darstellung der Erfindung

Das der Erfindung zugrunde liegende technische Problem besteht darin, eine technisch einfache und damit kostengünstigere Möglichkeit zur Sauberhaltung von Fenstern in Gasentladungslasern bereitzustellen.

Dieses technische Problem wird vorzugsweise durch einen Gasentladungslaser gelöst, der eine Entladungsröhre umfasst, in der sich ein Gas befindet und die zumindest ein Fenster aufweist, durch das ein Laserstrahl austritt und an dem der Laserstrahl reflektiert wird. In der Entladungsröhre ist zumindest eine Gasentnahmestelle vorhanden, um eine Teilmenge des Gases in der Entladungsröhre insbesondere kontinuierlich abzuziehen und einem Sinterfilter zur Reinigung der entnommenen Gasmenge zuzuleiten. Der Sinterfilter reinigt das zugeführte Gas soweit als möglich von Staubpartikeln und dergleichen. Der gereinigte Gasstrom wird dann über zumindest eine Gaseinleitungsstelle im Bereich des zumindest einen Fensters eingeleitet, so dass durch den sauberen Gasstrom eine Verschmutzung des Fensters durch in der Entladungsröhre befindliche Staubpartikel verhindert wird. Zudem wird insbesondere das jeweilige Fenster von eventuell daran anhaftenden Staubpartikeln freigespült. Vorzugsweise wirkt der gereinigte Gasstrom entgegen der durch die Entladung erzeugten Druckwellen, die Staubpartikel von der Entladung weg - und u.a. auf die Fenster zu - befördern.

Der Erfindung liegt der Gedanke zugrunde, erstmals ein Sinterfilter zur Reinigung eines der Entladungsröhre entnommenen Gasstroms einzusetzen. Wie aus den vorherigen Ausführungen zum Stand der Technik hervorgeht, hat man bisher zur Reinigung der Gase in technischen Geräten der hier interessierenden Art immer elektrostatische Filter eingesetzt. In überraschender Weise hat es sich aber gezeigt, dass Sinterfilter trotz ihres an sich hohen Strömungswiderstandes, der vom Gasstrom zu überwinden ist, auch bei Gasentladungslasern der eingangs genannten Art, verwendbar sind. Mit Sinterfiltern ist erstmals eine kostengünstige als auch wartungsfreundliche Alternative bzw. Ergänzung zu den bisherigen elektrostatischen Filtern gegeben. Insbesondere können nun die mit elektrostatischen Filtern einhergehenden Probleme umgangen werden.

Vorzugsweise ist in der Entladungsröhre eine Umwälzeinrichtung vorhanden, die das in der Entladungsröhre befindliche Gas umwälzt und gleichzeitig den Gasstrom von der Entnahmestelle durch den Sinterfilter hindurch bis zur Gaseinleitungsstelle fördert. Mit anderen Worten: die gesamte Zirkulation des durch das Sinterfilter durchzuleitenden Gasstroms wird durch die an sich vorhandene Umwälzeinrichtung geleistet und es ist insbesondere kein zusätzliches und damit teueres Pumpmittel notwendig. Diese Ausbildung hat also den Vorteil, dass die an sich vorhandene Umwälzeinrichtung in der Entladungsröhre auch gleichzeitig zur Erzeugung des Gasstroms durch das Sinterfilter hindurch verwendet werden kann, ohne dass aufwendige Modifikationen der Umwälzeinrichtung notwendig sind. Es hat sich nämlich überraschenderweise gezeigt, dass die Förderung eines Gasstromes durch einen an sich mit hohem Strömungswiderstand behafteten Sinterfilter auch mit den bisherigen Mitteln möglich ist.

Bei einer bevorzugten Ausführungsform ist eine einzige Gasentnahmestelle zur Entnahme von Gas aus der Entladungsröhre vorhanden. Von dieser einzigen Gasentnahmestelle werden mehrere Gaseinleitungsstellen für mehrere Fenster gespeist. Bei dieser Ausführungsform ist also nur eine Entnahmestelle in der Entladungsröhre notwendig, dafür ist allerdings ein verzweigtes Gasleitungssystem zu den einzelnen Fenstern erforderlich. Bei dieser Ausführungsform ist es denkbar, für alle Fenster einen gemeinsamen Sinterfilter vorzusehen. Es ist aber auch möglich, nach der Verzweigung von der gemeinsamen Gasentnahmestelle in jeder Leitung ein Sinterfilter einzusetzen.

Bei einer bevorzugten Ausführungsform sind mehrere Gasentnahmestellen zur Entnahme von Gas aus der Entladungsröhre vorhanden und jede Entnahmestelle ist einem Fenster zugeordnet. In den zugehörigen Gasführungsleitungen ist zudem jeweils ein Sinterfilter eingebaut. Diese Ausführungsform hat den Vorteil, dass kurze Leitungswege zu den Fenstern ausreichen, wodurch auch der Leitungswiderstand gering gehalten wird.

Vorzugsweise ist die zumindest eine Gasentnahmestelle zur Entnahme von Gas aus der Entladungsröhre am Austritt der Umwälzeinrichtung vorhanden. Damit wird die kinetische Energie des umgewälzten Gases in der Entladungsröhre in optimaler Weise in einen Gasforderstrom in Richtung des Sinterfilters umgesetzt.

Wie bereits erwähnt, ist die Umwälzeinrichtung vorzugsweise eine Lüfterwalze, die an sich in einem Gasentladungslaser wie einem Excimer-Laser vorhanden ist.

Indem zumindest eine Gasentnahrnestelle zur Entnahme von Gas aus der Entladungsröhre am Ende der Lüfterwalze angeordnet ist, und die Lüfterwalze in diesem Bereich länger ist als an der Entladungsröhre befindliche Elektroden, ist in optimaler Weise eine Gasführung zu den Sinterfiltern und den jeweiligen Fenstern durchführbar und gleichzeitig der konstruktive Aufwand minimiert.

Vorzugsweise ist die Gasentnahmestelle als Entnahmestutzen aus Isolatormaterial ausgebildet. Alternativ hierzu ist es auch denkbar, dass der Entnahmestutzen in hinreichender Entfernung zu Hochspannung führenden Bauteilen angeordnet ist. In diesem Fall ist die Materialauswahl nicht auf Isolatonnaterialien begrenzt.

Um zu verhindern, dass größere Mengen von Gas, das mit Staubpartikeln verunreinigt ist, zu den jeweiligen Fenstern gelangen, ist es bevorzugt, dass eine Trennwand vor dem zumindest einen Fenster angeordnet ist, die eine verglichen mit dem Röhrenquerschnitt der Entladungsröhre kleine Öffnung aufweist, die einen durch die Trennwand gebildeten Vorraum vor dem Fenster und das Innere der Entladungsröhre miteinander verbindet. In diesen Vorraum mündet die Gaseinleitungsstelle ein.

Selbstverständlich ist es bei bevorzugten Ausführungsformen der Erfindung weiterhin möglich, zusätzlich die an sich bekannten Mittel einzusetzen, die möglichst verhindern, dass Staub aus der Entladungsröhre an die Fenster gelangen.

Das eingangs genannte technische Problem wird zudem durch ein Verfahren zum Betreiben eines Gasentladungslasers wie beispielsweise ein Excimer-Laser mit Entladungsröhre gelöst, in der sich ein Gas befindet und die zumindest ein Fenster aufweist, durch das ein Laserstrahl austritt oder an dem der Laserstrahl reflektiert wird. Erfindungsgemäß wird zumindest eine Teilmenge des in der Entladungsröhre enthaltenen Gases in einem Sinterfilter gereinigt und im Bereich des zumindest einen Fensters wieder eingeleitet, und zwar derart, das ein vom Fenster weggerichteter Gasstrom entsteht.

Vorzugsweise wird eine in der Entladungsröhre vorhandene Umwälzeinrichtung zur stetigen Umwälzung des in der Entladungsröhre befindlichen Gases auch dazu genutzt, den aus der Entladungsröhre entnommenen Gasstrom durch den Sinterfilter zum Fenster hin zu fördern. Damit wird eine separate Umwälzpumpe oder dergleichen vermieden und gleichzeitig der konstruktive Aufwand für die Verwendung des Sinterfilters klein gehalten.

Wie bereits eingangs erwähnt ist also erstmals in überraschender Weise die Verwendung eines Sinterfilters zum Reinigen eines aus der Entladungsröhre eines Gasentladungslasers entnommenen Gasstroms vorgeschlagen, der zu Reinigungszwecken zu einem Fenster der Entladungsröhre gerichtet ist.

Abschließend sei hier noch darauf hingewiesen, dass insbesondere Sinterfilter mit Porengrößen bis zu 10.000 nm und mehr verwendbar sind. Insbesondere bevorzugt man Sinterfilter mit Porengrößen zwischen 2 und 100 nm. Als Filtermaterial derartiger Sinterfilter kommen beispielsweise Nickel, Edelstahl oder Hastelloy - Legierung zum Einsatz. Von dieser Gruppe wird besonders Nickel bevorzugt. Filter der genannten Art werden beispielsweise von der Fa. Mott aus Conneticut/USA hergestellt.

### Kurze Beschreibung der Zeichnungen

Im Folgenden ist zur weiteren Erläuterung und zum besseren Verständnis ein Ausführungsbeispiel der Erfindung unter Bezugnahme auf die beigefügten Zeichnungen näher beschrieben. Es zeigt:
- Fig. 1: einen schematischen Querschnitt durch eine Entladungsröhre eines Excimer-Lasers mit Gasentnahme- und Gaszuführungssystem mit darin eingebautem Sinterfilter,
- Fig. 2: einen Längsschnitt entlang der Linie A-A in Fig. 1, und
- Fig. 3: eine vergrößerte Teilansicht des in der Fig. 2 gezeigten Schnittes.

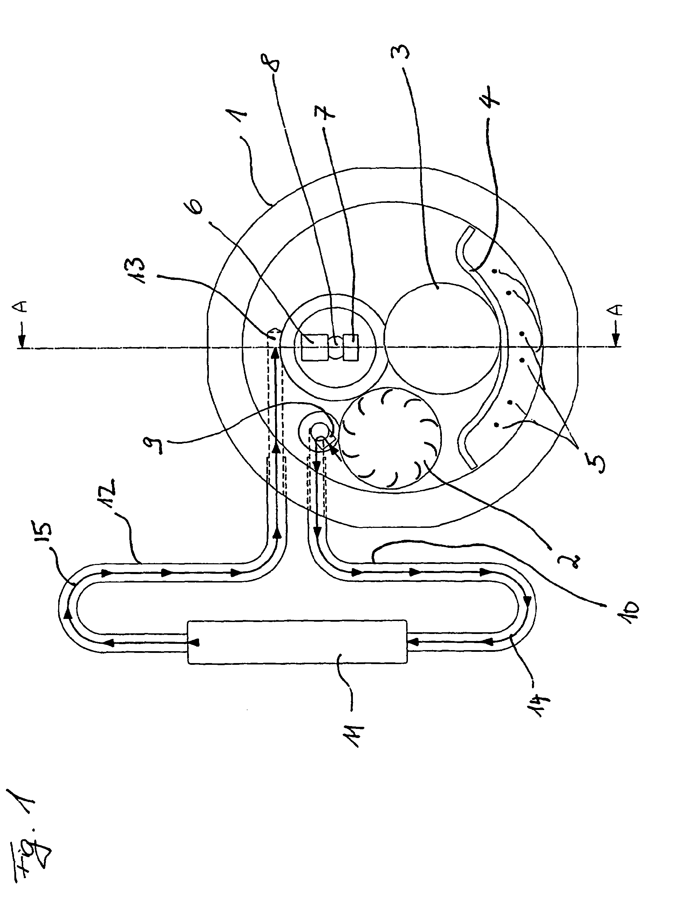

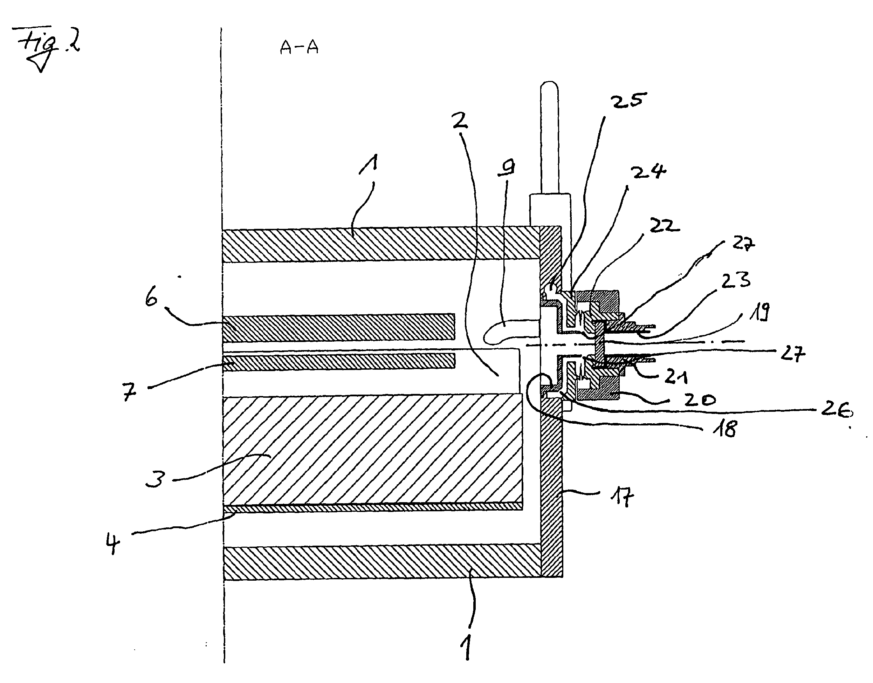

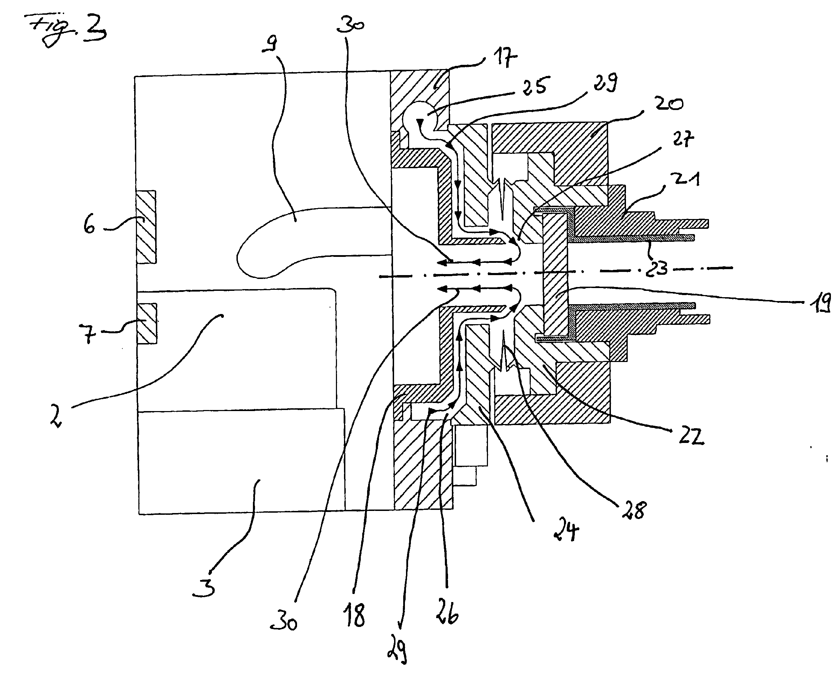

Wie in der Fig. 1 gezeigt, umfasst ein Excimer-Laser eine Entladungsröhre 1, die als länglicher Zylinder ausgebildet ist, der an seinen beiden Stirnseiten durch einen Stirnflansch 17 (siehe Fig. 2 und 3) abgeschlossen ist. In der Gasentladungsröhre 1 erstrecken sich in deren Längsrichtung zwei Elektroden 6, 7, die voneinander beabstandet sind. In der Höhe des freien Zwischenraums zwischen den beiden Elektroden 6, 7 ist stimseitig eine Austrittsöffnung 8 angeordnet, die durch ein Fenster 19 verschlossen ist. Bei dem Fenster 19 kann es sich um ein Austrittsfenster oder einen Spiegel handeln. Eine detaillierte Erläuterung der Halterung derartiger Fenster 19 erfolgt später anhand der Fig. 2 und 3.

Unterhalb der Elektroden 6, 7 ist eine Kühlung 3 angeordnet, die sich, wie aus der Fig. 2 ersichtlich ist, im Wesentlichen über die gesamte Länge der Entladungsröhre 1 erstreckt. Unterhalb der Kühlung 3 befindet sich ein Staubabscheider 5, der durch ein Deckblech 4 abgedeckt ist.

In der Schnittansicht gemäß der Fig. 1 ist ferner linksseitig im Inneren der Entladungsröhre 1 eine Lüfterwalze 2 vorhanden, die mit einzelnen Schaufeln ausgestattet ist, um das Gas in der Entladungsröhre 1 umzuwälzen. Die Lüfterwalze 2 erstreckt sich ebenfalls fast über die gesamte Länge der Entladungsröhre 1 und ist insbesondere länger als die Elektroden 6, 7, was sich aus der Darstellung gemäß den Fig. 2 und 3 entnehmen lässt. Das heißt, die Lüfterwalze 2 steht in Längsrichtung der Entladungsröhre 1 gegenüber den Elektroden 6, 7 an deren beiden Enden über.

Wie aus den Fig. 2 und 3 zu entnehmen ist, weist jeder Stirnflansch 17 eine Austrittsöffnung 8 auf, die durch ein Fenster 19 verschlossen ist. In der gezeigten Darstellung ist das Fenster ein Austrittsfenster 19, durch das der erzeugte Laserstrahl aus der Entladungsröhre 1 austritt. Das Fenster 19 ist in einem Optikhalter 23 eingesetzt, der hierfür eine ringförmige Auskragung aufweist. Der Optikhalter 23 wird wiederum durch eine Optikmutter 21 gegen einen ersten Optikflansch 22 gedrückt, so dass das Fenster 19 zwischen dem Optikflansch 22 und dem Optikhalter 23 eingeklemmt ist. Der Optikflansch 22 ist über einen Balg 28 mit einem zweiten Optikflansch 24 verbunden. Letzterer ist in dem Stirnflansch 17 gehalten.

Über einen verstellbaren Optikhalter 20 ist die gesamte Optik durch Verkippen in drei Richtungen einstellbar. Der Optikhalter 20 ist am Stirnflansch 17 der Entladungsröhre 1 durch drei Schrauben gehalten, von denen eine fest ist, eine zweite einen Freiheitsgrad aufweist und die dritte zwei Freiheitsgrade aufweist. Prinzipiell lässt sich der Optikhalter 20 auch zur Einstellung der Spaltweite eines Gaseintrittsringspaltes 27 zwischen dem Optikflansch 22 und einer Strömungsführung 18 verwenden, wodurch auch die zum Fenster 19 hin gerichtete gereinigte Gasströmung 29 sowohl in der Menge als auch in der Geschwindigkeit einstellbar ist. Hierzu müsste der verstellbare Optikhalter 20 mit der gleichen Winkeleinstellung in Laserstrahlrichtung verschoben werden, die nach Justage der Optik feststeht. In der Praxis hat aber die Justage der Optik (Winkelausrichtung) mittels des verstellbaren Optikhalters 20 gegenüber der Einstellung der Spaltweite Vorrang.

Der Gaseintrittsringspalt 27 ist mit einem Gasführungsringspalt 26 verbunden, der von einer Gaseinströmungsöffnung 25 gespeist wird. Der Gasführungsringspalt 26 wie auch der Gaseintrittsringspalt 27 sind in ihren Abmessungen durch die Strömungsführung 18 und den Optikflansch 24 vorgegeben.

Es wird nochmals auf die Fig. 1 Bezug genommen. Wie hieraus ersichtlich ist, ist in der Nähe der Lüfterwalze 2 ein Gasentnahmestutzen 9 vorhanden, durch den aufgrund der kinetischen Energie des umgewälzten Gases in der Entladungsröhre 1 ein ungereinigter Gasstrom 14 kontinuierlich entnommen wird. Hierzu ist der Entnahmestutzen 9 über eine Gasführungsleitung 10 mit einem Sinterfilter 11 verbunden. Das Sinterfilter 11 ist wiederum mit einer Gasführungsleitung 12 verbunden, die in eine Zuführungsbohrung 13 im Stirnflansch 17 mündet. Das Sinterfilter 11 ist hier außerhalb der Entladungsröhre 1 untergebracht und damit in optimaler Weise und äußerst einfach zu Wartungszwecken austauschbar bzw. reinigbar.

Durch den Entnahmestutzen 9 wird also eine Teilmenge des ungereinigten Gases in der Entladungsröhre 1 kontinuierlich entnommen, strömt als Gasstrom 14 in das Sinterfilter 11 und wird darin gereinigt. Der gereinigte Gasstrom 15 strömt durch die Gasführungsleitung 12 bis zur Zuführungsbohrung 13 und mündet dort in die Gaseinströmungsöffnung 25 im Stirnflansch 17. Dort wird sie ringförmig verteilt und strömt durch den Gaseintrittsringspalt 27 schräg in Richtung des Fensters 19. Schräg bedeutet hier, dass zwischen der Hauptströmungsrichtung des Gasstroms im Gaseintrittsringspalt 27und der Mittelachse des Fensters 19 ein Winkel von etwa 45° eingeschlossen ist, der Winkel kann aber auch zwischen 10° und 80° variieren.

Der aus dem Gaseintrittsringspalt 27 auf das Fenster 19 treffende Gasstrom sorgt für eine Reinigung des Fensters 19 und wird dann in Richtung zu den Elektroden 6 und 7 abgelenkt und strömt vom Fenster weggerichtet (Gasstrom 30) wieder in das Innere der Entladungsröhre 1.

### Bezugszeichenliste

- 1: Entladungsröhre
- 2: Lüfterwalze
- 3: Kühlung
- 4: Deckblech Staubabscheider
- 5: Staubabscheider
- 6: Elektrode
- 7: Elektrode
- 8: Austrittsöffnung
- 9: Entnahmestutzen
- 10: Gasführungsleitung
- 11: Sinterfilter
- 12: Gasführungsleitung
- 13: Zuführungsbohrung
- 14: Gasstrom (ungereinigt)
- 15: Gasstrom (gereinigt)
- 16: ---
- 17: Stirnflansch
- 18: Strömungsführung
- 19: Fenster (Austrittsfenster oder Spiegel)
- 20: verstellbarer Optikhalter
- 21: Optikmutter
- 22: Optikflansch
- 23: Optikhalter
- 24: Optikflansch
- 25: Gaseinströmungsöffnung
- 26: Gasführungsringspalt
- 27: Gaseintrittsringspalt
- 28: Zwischenbalg
- 29: Gasstrom (zum Fenster hin gerichtet)
- 30: Gasstrom (vom Fenster weg gerichtet)

## Patentansprüche

1. Gasentladungslaser mit
- einer Entladungsröhre (1), in der sich ein Gas befindet und die zumindest ein Fenster (19) aufweist, durch das ein Laserstrahl austritt oder an dem der Laserstrahl reflektiert wird,
- zumindest einer Gasentnahmestelle (9) zur Entnahme einer Teilmenge des Gases in der Entladungsröhre (1),
- einem Filter (11) zur Reinigung der entnommenen Gasmenge und
- zumindest einer Gaseinleitungsstelle (27) im Bereich des Fensters (19), durch die das im Filter (11) gereinigte Gas einleitbar ist, **dadurch gekennzeichnet, dass** der Filter ein Sinterfilter ist.

2. Gasentladungslaser nach Anspruch 1, **dadurch gekennzeichnet, dass** in der Entladungsröhre (1) eine Umwälzeinrichtung (2) vorhanden ist, die das in der Entladungsröhre (1) befindliche Gas umwälzt und zudem den Gasstrom von der Entnahmestelle (9) durch den Sinterfilter (11) hindurch bis zur Gaseinleitungsstelle (27) fördert.

3. Gasentladungslaser nach Anspruch 1 oder 2, **dadurch gekennzeichnet, dass** eine einzige Gasentnahmestelle (9) zur Entnahme von Gas aus der Entladungsröhre (1) vorhanden ist, mit der mehrere Gaseinleitungsstellen (27) für mehrere Fenster (19) verbunden sind.

4. Gasentladungslaser nach Anspruch 1 oder 2, **dadurch gekennzeichnet, dass** mehrere Gasentnahmestellen (9) zur Entnahme von Gas aus der Entladungsröhre (1) vorhanden sind, und jede Entnahmestelle (9) einem Fenster (19) zugeordnet ist.

5. Gasentladungslaser nach einem der voranstehenden Ansprüche, **dadurch gekennzeichnet, dass** die zumindest eine Gasentnahmestelle (9) zur Entnahme von Gas aus der Entladungsröhre (1) am Austritt der Umwälzeinrichtung (2) vorhanden ist.

6. Gasentladungslaser nach einem der voranstehenden Ansprüche, **dadurch gekennzeichnet, dass** die Umwälzeinrichtung eine Lüfterwalze (2) ist.

7. Gasentladungslaser nach Anspruch 6, **dadurch gekennzeichnet, dass** die zumindest eine Gasentnahmestelle (9) zur Entnahme von Gas aus der Entladungsröhre (1) am Ende der Lüfterwalze (2) angeordnet ist und die Lüfterwalze (2) in diesem Bereich länger ist als in der Entladungsröhre (1) befindliche Elektroden (6, 7).

8. Gasentladungslaser nach einem der voranstehenden Ansprüche, **dadurch gekennzeichnet, dass** ein Entnahmestutzen (9) aus Isolatormaterial als Gasentnahmestelle vorhanden ist.

9. Gasentladungslaser nach einem der Ansprüche 1-7, **dadurch gekennzeichnet, dass** ein Entnahmestutzen (9) als Gasentnahmestelle vorhanden und in hinreichender Entfernung zu Hochspannung führenden Bauteilen angeordnet ist.

10. Gasentladungslaser nach einem oder mehreren der voranstehenden Ansprüche, **dadurch gekennzeichnet, dass** eine Trennwand vor dem zumindest einen Fenster (9) angeordnet ist, die eine verglichen mit dem Röhrenquerschnitt der Entladungsröhre (1) kleine Öffnung aufweist, die einen durch die Trennwand gebildeten Vorraum vor dem Fenster (9) und das Innere der Entladungsröhre (1) miteinander verbindet, wobei die Gaseinleitungsstelle (27) in diesem Vorraum angeordnet ist.

11. Gasentladungslaser nach einem der voranstehenden Ansprüche, **dadurch gekennzeichnet, dass** Mittel vorhanden sind, die möglichst verhindern, dass Staub aus der Entladungsröhre (1) an das Fenster (19) gelangt.

12. Gasentladungslaser mit
- einer Entladungsröhre (1), in der sich ein Gas befindet und die zumindest ein Fenster (19) aufweist, durch das ein Laserstrahl austritt oder an dem der Laserstrahl reflektiert wird,
- zumindest zwei Gasentnahmestellen (9) zur Entnahme von Gas aus der Entladungsröhre (1), wobei jede Entnahmestelle (9) jeweils einem Fenster (19) zugeordnet ist,
- jeweils einem Sinterfilter (11) im Verlauf der zu den zumindest zwei Gasentnahmestellen (9) zugehörigen Gasführungsleitungen zur Reinigung der jeweils entnommenen Gasmenge, und
- zumindest jeweils einer Gaseinleitungsstelle (27) im Bereich der jeweiligen Fenster (19), durch die die in den Sinterfiltern (11) gereinigten Gase einleitbar sind.

13. Verfahren zum Betreiben eines Gasentladungslaser mit Entladungsröhre (1), in der sich ein Gas befindet und die zumindest ein Fenster (19) aufweist, durch das ein Laserstrahl austritt oder an dem der Laserstrahl reflektiert wird, wobei zumindest eine Teilmenge des in der Entladungsröhre (1) enthaltenen Gases entnommen, in einem Filter (11) gereinigt und im Bereich des zumindest einen Fensters (19) wieder eingeleitet wird, und zwar derart, dass ein vom Fenster (19) weg gerichteter Gasstrom (30) entsteht, **dadurch gekennzeichnet**, das der Filter ein Sinterfilter ist.

14. Verfahren nach Anspruch 13, **dadurch gekennzeichnet, dass** das Gas in der Entladungsröhre (1) mittels einer Umwälzeinrichtung (2) stetig umgewälzt wird und mit der selben Umwälzeinrichtung (2) die Förderung des aus der Entladungsröhre (1) entnommenen Gasstroms (14) durch den Sinterfilter (11) zum Fenster (19) hin erfolgt.

15. Verfahren nach Anspruch 14; **dadurch gekennzeichnet, dass** die Entnahme von Gas aus der Entladungsröhre (1) am Austritt der Umwälzeinrichtung (2) zur Umwälzung des Gases in der Entladungsröhre (1) erfolgt.

16. Verfahren nach Anspruch 14 oder 15, **dadurch gekennzeichnet, dass** die Umwälzeinrichtung eine Lüfterwalze (2) ist.

17. Verfahren nach Anspruch 16, **dadurch gekennzeichnet, dass** die Entnahme von Gas aus der Entladungsröhre (1) am Ende der Lüfterwalze (2) erfolgt und die Lüfterwalze (2) in diesem Bereich länger ist als in der Entladungsröhre (1) befindliche Elektroden (6, 7).

18. Verfahren nach einem der Ansprüche 13-17, **dadurch gekennzeichnet, dass** die Entladungsröhre (1) mehrere mit einem Gasstrom zu beaufschlagende Fenster (9) aufweist, eine Gasteilmenge jedoch nur an einer einzigen gemeinsamen Stelle entnommen wird, die entnommene Gasmenge in einem einzigen Sinterfilter (11) gereinigt und nach der Reinigung auf die Fenster (9) verteilt wird.

19. Verfahren nach einem der Ansprüche 13-17, **dadurch gekennzeichnet, dass** die Entladungsröhre (1) mehrere Fenster (19) aufweist und in entsprechender Anzahl von Stellen Gasteilmengen aus der Entladungsröhre (1) entnommen, in jeweils einem Sinterfilter (11) gereinigt und dann jeweils zu einem Fenster (9) geführt werden.

20. Verfahren nach einem oder mehreren der Ansprüche 13-19, **dadurch gekennzeichnet, dass** eine Trennwand vor dem zumindest einen Fenster (19) angeordnet ist, die eine verglichen mit dem Röhrenquerschnitt der Entladungsröhre (1) kleine Öffnung aufweist, die einen von der Trennwand gebildeten Vorraum vor dem Fenster (19) und das Innere der Entladungsröhre (1) miteinander verbindet, wobei das im Sinterfilter (11) gereinigte Gas in den Vorraum eingeleitet wird.

21. Verwendung eines Sinterfilters zum Reinigen eines aus einer Entladungsröhre (1) eines Gasentladungslasers entnommenen Gasstroms, der zu Reinigungszwecken zu einem Fenster (19) der Entladungsröhre (1) gerichtet ist.

## Claims

1. A gas discharge laser including
- a discharge tube (1), in which a gas is present, and which has at least one window (19) through which a laser beam emerges or at which the laser beam is reflected,
- at least one gas extraction point (9) for extracting a proportion of the gas present in the discharge tube (1),
- a filter (11) for purifying the extracted amount of gas, and
- at least one gas inlet point (27) in the area of the window (19) through which the gas purified in the filter (11) can be conveyed,
**characterized in that** the filter is a sintering filter.

2. The gas discharge laser of claim 1,
**characterized in that** within said discharge tube (1), a circulation means (2) is present for circulating the gas contained in the discharge tube (1) and in addition for conveying the gas flow from the extraction point (9) through the sintering filter (11) to the gas inlet point (27).

3. The gas discharge laser of claim 1 or 2, **characterized in that** a single gas extraction point (9) is present for extracting gas from the discharge tube (1), to which gas extraction point several gas inlet points (27) for several windows (19) are connected.

4. The gas discharge laser of claim 1 or 2, **characterized in that** several gas extraction points (9) are present for extracting gas from the discharge tube (1), and each extraction point (9) is assigned to its own window (19).

5. The gas discharge laser of any one of the preceding claims, **characterized in that** the at least one gas extraction point (9) for extracting gas from the discharge tube (1) is present at the outlet of the circulation means (2).

6. The gas discharge laser of any one of the preceding claims,
**characterized in that** the circulation means is a ventilator drum (2).

7. The gas discharge laser of claim 6,
**characterized in that** the at least one gas extraction point (9) for extracting gas from the discharge tube (1) is arranged at the end of the ventilator drum (2), and **in that** the ventilator drum (2) in said zone is longer than electrodes (6, 7) located in the discharge tube (1).

8. The gas discharge laser of any one of the preceding claims,
**characterized in that** a sampling tube (9) of an insulating material is present as the gas extraction point.

9. The gas discharge laser of any one of claims 1 through 7,
**characterized in that** a sampling tube (9) is present as the gas extraction point, and is arranged at a sufficient distance from the components carrying high voltage.

10. The gas discharge laser according to one or more of the preceding claims,
**characterized in that** a partition is arranged in front of the at least one window (9), which has, as compared to the tube cross-section of the discharge tube (1), a small opening interconnecting a pre-chamber formed by the partition in front of the window (9) and the interior of the discharge tube (1), the gas inlet point (27) being arranged in said pre-chamber.

11. The gas discharge laser of any one of the preceding claims,
**characterized in that** means are present, to prevent if possible dust from the discharge tube (1) from reaching the window (19).

12. A gas discharge laser having
- a discharge tube (1), in which a gas is present, and which has at least one window (19) through which a laser beam emerges or at which the laser beam is reflected,
- at least two gas extraction points (9) for extracting gas from the discharge tube (1), each extraction point (9) being assigned to its own window (19),
- a sintering filter (11) for purifying the respective amounts of gas extracted and located along the gas conveying conduits allotted to the at least two gas extraction points (9), and
- at least one gas inlet point (27) in the area of the respective window (19) through which the gases purified in the sintering filter can be conveyed.

13. Method of operating a gas discharge laser including a discharge tube (1) in which a gas is present and which has at least one window (19) through which a laser beam emerges or at which the laser beam is reflected, wherein at least a proportion of the gas contained in the discharge tube (1) is extracted, is purified in a filter (11) and then conveyed back in the area of the at least one window (19) in such a way that a gas flow (30) directed away from said window (19) is created,
**characterized in that** the filter is a sinter filter.

14. Method of claim 13,
**characterized in that** the gas present in the discharge tube (1) is continuously circulated by means of a circulation means (2), and that the conveyance of the gas flow (14) extracted from the discharge tube (1) through the sintering filter (11) towards the window (19) occurs by means of the same circulation means (2).

15. Method of claim 14,
**characterized in that** the extraction of gas from the discharge tube (1) occurs at the outlet of the circulation means (2) for circulating the gas in the discharge tube (1).

16. Method of claim 14 or 15,
**characterized in that** the circulation means is a ventilator drum (2).

17. Method of claim 16,
**characterized in that** the extraction of gas from the discharge tube (1) occurs at the end of the ventilator drum (2), and **in that** the ventilator drum (2) is longer in this zone than electrodes (6, 7) located in the discharge tube (1).

18. Method of any one of claims 13-17,
**characterized in that** the discharge tube (1) has several windows (9) to be supplied with a gas flow, however only a proportion of the gas is extracted at one common point, said extracted proportion of gas is purified in a single sintering filter (11), and is distributed among the windows (9) after the purifying process.

19. Method of any one of claims 13-17,
**characterized in that** the discharge tube (1) has several windows (19), and **in that** at a corresponding number of points, amounts of gas are extracted from the discharge tube (1), in each case purified in a sintering filter (11), and then conveyed to a window (9).

20. Method according to one or more of claims 13-19,
**characterized in that** a partition is arranged in front of the at least one window (19), which partition has, as compared to the tube cross-section of the discharge tube (1), a small opening interconnecting a pre-chamber formed by the partition in front of the window (19) and the interior of the discharge tube (1), the gas purified in the sintering filter (11) being conveyed into said pre-chamber.

21. Use of a sintering filter for purifying a gas flow extracted from the discharge tube (1) of a gas discharge laser, which gas flow is directed towards a window (19) of the discharge tube (1) for purifying purposes.

## Revendications

1. Laser à décharge gazeuse avec
- un tuyau de décharge (1) dans lequel se trouve un gaz et qui présente au moins une fenêtre (19), par laquelle un faisceau laser sort ou au niveau de laquelle un faisceau laser est réfléchi,
- au moins un emplacement de prélèvement de gaz (9) pour prélever une quantité partielle de gaz dans le tuyau de décharge (1),
- un filtre (11) pour le nettoyage de la quantité de gaz prélevée et
- au moins un emplacement d'introduction de gaz (27) dans la zone de la fenêtre (19), via lequel il est possible d'introduire le gaz nettoyé dans le filtre (11), **caractérisé en ce que** le filtre est un filtre fritté.

2. Laser à décharge gazeuse selon la revendication 1, **caractérisé en ce qu'**un dispositif de brassage (2) se trouve dans le tuyau de décharge (1), lequel brasse le gaz se trouvant dans le tuyau de décharge (1), et qui achemine par ailleurs le courant gazeux depuis l'emplacement de prélèvement (9), en passant par le filtre fritté (11), jusqu'à l'emplacement d'introduction de gaz (27).

3. Laser à décharge gazeuse selon les revendications 1 ou 2, **caractérisé en ce qu'**il existe un seul emplacement de prélèvement de gaz (9) pour prélever le gaz dans le tuyau de décharge (1), lequel est en liaison avec plusieurs emplacements d'introduction de gaz (27) pour plusieurs fenêtres (19).

4. Laser à décharge gazeuse selon les revendications 1 ou 2, **caractérisé en ce qu'**il existe plusieurs emplacements de prélèvement de gaz (9) pour le prélèvement du gaz dans le tuyau de décharge (1), et **en ce que** chaque emplacement de prélèvement (9) est affecté à une fenêtre (19).

5. Laser à décharge gazeuse selon l'une quelconque des revendications précédentes, **caractérisé en ce que** cet au moins un emplacement de prélèvement de gaz (9) pour le prélèvement de gaz dans le tuyau de décharge (1) se trouve à la sortie du dispositif de brassage (2).

6. Laser à décharge gazeuse selon l'une quelconque des revendications précédentes, **caractérisé en ce que** le dispositif de brassage est un cylindre de ventilation (2).

7. Laser à décharge gazeuse selon la revendication 6, **caractérisé en ce que** cet au moins un emplacement de prélèvement de gaz (9) pour le prélèvement du gaz dans le tuyau de décharge (1) est disposé au niveau de l'extrémité du cylindre de ventilation (2), et **en ce que** le cylindre de ventilation (2) est plus long dans cette zone que les électrodes (6, 7) se trouvant dans le tuyau de décharge (1).

8. Laser à décharge gazeuse selon l'une quelconque des revendications précédentes, **caractérisé en ce qu'**il existe un raccord de prise (9) en une matière isolante en guise d'emplacement de prélèvement de gaz.

9. Laser à décharge gazeuse selon l'une quelconque des revendications 1-7, **caractérisé en ce qu'**il existe un raccord de prise (9) en guise d'emplacement de prélèvement de gaz, lequel est disposé à distance suffisante d'éléments conducteurs de haute tension.

10. Laser à décharge gazeuse selon l'une quelconque ou plusieurs des revendications précédentes, **caractérisé en ce qu'**une cloison est disposée devant au moins l'une des fenêtres (9), laquelle présente une petite ouverture en comparaison avec la section de tuyau du tuyau de décharge (1), laquelle ouverture relie ensembles une antichambre formée par la cloison devant la fenêtre (9) et l'intérieur du tuyau de décharge (1), l'emplacement d'introduction de gaz (27) étant disposé dans cette antichambre.

11. Laser à décharge gazeuse selon l'une quelconque des revendications précédentes, **caractérisé en ce qu'**il existe des moyens, lesquels évitent autant que possible que de la poussière provenant du tuyau de décharge (1) ne gagne la fenêtre (19).

12. Laser à décharge gazeuse avec
- un tuyau de décharge (1) dans lequel se trouve un gaz et qui présente au moins une fenêtre (19), par laquelle un faisceau laser sort ou au niveau de laquelle un faisceau laser est réfléchi,
- au moins deux emplacements de prélèvement de gaz (9) pour prélever du gaz dans le tuyau de décharge (1), chaque emplacement de prélèvement (9) étant respectivement affecté à une fenêtre (19),
- respectivement un filtre fritté (11) sur le trajet des tuyaux d'acheminement du gaz faisant partie des au moins deux emplacements de prélèvement de gaz (9) pour le nettoyage de la quantité de gaz respectivement prélevée, et
- au moins respectivement un emplacement d'introduction de gaz (27) dans la zone de la fenêtre (19) respective, via lesquels il est possible d'introduire les gaz nettoyés dans le filtre (11).

13. Procédé pour faire fonctionner un laser à décharge gazeuse avec un tuyau de décharge (1) dans lequel se trouve un gaz et qui présente au moins une fenêtre (19), par laquelle un faisceau laser sort ou au niveau de laquelle un faisceau laser est réfléchi, au moins une quantité partielle du gaz contenu dans le tuyau de décharge (1) étant prélevée, étant nettoyée dans un filtre (11), et étant à nouveau introduite dans la zone de l'au moins une fenêtre (19), et ce de manière à ce qu'un courant gazeux (30) orienté en opposition à la fenêtre (19) soit généré, **caractérisé en ce que** le filtre est un filtre fritté.

14. Procédé selon la revendication 13, **caractérisé en ce que** le gaz dans le tuyau de décharge (1) est brassé de manière régulière à l'aide d'un dispositif de brassage (2), et **en ce que** l'acheminement du courant gazeux (14) prélevé dans le tuyau de décharge (1), en passant à travers le filtre fritté (11) et jusqu'à la fenêtre (19), s'effectue avec le même dispositif de brassage (2).

15. Procédé selon la revendication 14, **caractérisé en ce que** le prélèvement de gaz dans le tuyau de décharge (1) s'effectue à la sortie du dispositif de brassage (2) pour le brassage du gaz dans le tuyau de décharge (1).

16. Procédé selon les revendications 14 ou 15, **caractérisé en ce que** le dispositif de brassage est un cylindre de ventilation (2).

17. Procédé selon la revendication 16, **caractérisé en ce que** le prélèvement de gaz dans le tuyau de décharge (1) s'effectue à l'extrémité du cylindre de ventilation (2), et **en ce que** le cylindre de ventilation (2) est plus long dans cette zone que des électrodes (6, 7) se trouvant dans le tuyau de décharge (1).

18. Procédé selon l'une quelconque des revendications 13-17, **caractérisé en ce que** le tuyau de décharge (1) présente plusieurs fenêtres (9) à alimenter avec un courant gazeux, une quantité partielle de gaz étant cependant prélevée uniquement au niveau d'un seul emplacement commun, la quantité de gaz prélevée étant nettoyée dans un seul filtre fritté (11) et étant répartie vers les fenêtres (9) après le nettoyage.

19. Procédé selon l'une quelconque des revendications 13-17, **caractérisé en ce que** le tuyau de décharge (1) présente plusieurs fenêtres (19), et **en ce qu'**au niveau d'emplacements en quantités correspondantes, des quantités partielles de gaz sont prélevées dans le tuyau de décharge (1), sont respectivement nettoyées dans un filtre fritté (11), et sont ensuite respectivement acheminées vers une fenêtre (9).

20. Procédé selon l'une quelconque ou plusieurs des revendications 13-19, **caractérisé en ce qu'**une cloison est disposée devant cette au moins une fenêtre (19), laquelle cloison présente une petite ouverture en comparaison avec la section de tuyau du tuyau de décharge (1), laquelle ouverture relie ensembles une antichambre formée par la cloison devant la fenêtre (19) et l'intérieur du tuyau de décharge (1), le gaz nettoyé dans le filtre fritté (11) étant introduit dans l'antichambre.

21. Utilisation d'un filtre fritté pour nettoyer un courant gazeux prélevé dans un tuyau de décharge (1) d'un laser à décharge gazeuse, lequel est orienté vers une fenêtre (19) du tuyau de décharge (1) pour des besoins de nettoyage.
